Europäisches Patentamt

European Patent Office

Office européen des brevets

(11) Publication number: **0 455 245 A2**

# EUROPEAN PATENT APPLICATION

(21) Application number: 91107128.0

(22) Date of filing: 02.05.91

(51) Int. Cl.5: **H01L 23/495**

(30) Priority: 02.05.90 JP 115208/90

(43) Date of publication of application:
06.11.91 Bulletin 91/45

(84) Designated Contracting States:
DE FR GB

(71) Applicant: Kabushiki Kaisha Toshiba
72, Horikawa-cho Saiwai-ku
Kawasaki-shi(JP)

(72) Inventor: Yanagida, Satoru, c/o Intellectual
Property Div.
KABUSHIKI KAISHA TOSHIBA, 1-1 Shibaura
1-chome
Minato-ku, Tokyo 105(JP)

Inventor: Araki, Kouji, c/o Intellectual Property
Div.
KABUSHIKI KAISHA TOSHIBA, 1-1 Shibaura
1-chome
Minato-ku, Tokyo 105(JP)
Inventor: Otsuka, Masashi, c/o Intellectual
Property Div.
KABUSHIKI KAISHA TOSHIBA, 1-1 Shibaura
1-chome
Minato-ku, Tokyo 105(JP)

(74) Representative: Lehn, Werner, Dipl.-Ing. et al
Hoffmann, Eitle & Partner Patentanwälte
Arabellastrasse 4
W-8000 München 81(DE)

(54) IC lead frame appropriate for multi-chip package.

(57) An IC lead frame according to the present inven-
tion is of, for example, an MCP (multi-chip package)
type in which a bed (11) is supported by a tie bar
(12). Leads (13) are formed around a bed (11). A
helper pin (14) is formed as it extends from a corner
of a side of the bed (11) , opposite to that from
which the tie bar (12) extends, between adjacent two
leads (13). The helper pin (14) has a width such that
the pin does not touch the leads (13) beside it, and a
length such that the distal end of the pin (14) is not
exposed together with the outer lead when bare
chips (15) are sealed. In the bonding step, a jig (17)
also holds the distal end of the helper pin (14) so as
to fix the bed (11).

FIG. 2

EP 0 455 245 A2

The present invention relates to a sealed-type IC lead frame used, especially, for an MCP (multi-chip package) or the like.

An MCP (multi-chip package) is a single package containing a plurality of not-yet-sealed bare chips (semiconductor chips). The configuration of an IC lead frame used in the package inevitably becomes complicated due to its tight arrangement. In addition, in consideration of minimization of the frame, there is, in many cases, only one tie bar (suspension pin) provided to support the bed of the lead frame. In regular cases, a tie bar is provided at both ends of the bed for the sake of balance, whereas the structure of an MCP does not allow as many tie bars as are fundamentally needed in the above-mentioned places, due to the tight layout in conjunction with the other chips in the MCP.

The above IC lead frame having only one tie bar for the bed incurs some difficulty in the chip bonding step. For example, when a bare chip is die-bonded to a bed of the lead frame, and wire-bonded to leads, the tie bar and the leads are fixed by means of a jig. The jig serves as a frame by which one end of each of the leads surrounding the bed and the periphery thereof are exposed, and the periphery of the lead frame, namely the mid-portion (the main body) of each lead, and the tie bar, are held. The leads and the tie bar are fixed by being sandwiched between this jig and the heater plate located underneath the lead frame. However, in reality, if a lead frame having only one tie bar at one end is pressed by means of the jig, the bed is not completely fixed due to the imbalance created by there being only one tie bar. Accordingly, the bed is likely to become shaky, and as a result, when the electrode pad of a chip and the leads are wire-bonded, bonding errors occur in many places.

The present invention has been achieved in consideration of the above, and the purpose thereof is to provide an IC lead frame by means of which bond performance is greatly improved, even in the case where there can be only one tie bar due to tight design requirements, as in an MCP and the like.

In order to achieve this purpose, the IC lead frame according to the present invention comprises bed, on which a semiconductor chip is fixed; a plurality of leads arranged at the periphery of the bed; and a bed-supporting helper pin extending from the bed between the leads so as to be held together with the leads by a jig which holds the lead frame during bonding of the semiconductor chips without reaching to an outer lead.

As state above, a helper pin is provided, in addition to the tie bar, to support the bed of the lead frame. With this structure, the bed can be fixed firmly on the lead frame, and therefore the bond strength between a chip and a lead can be enhanced during the bonding step, despite there being only one tie bar provided in an MCP or the like due to tight design requirements.

This invention can be more fully understood from the following detailed description when taken in conjunction with the accompanying drawings, in which:

Fig. 1 is a top view showing the characteristics of the main part of an IC lead frame according to the first embodiment of the present invention.

Fig. 2 is a top view illustrating a bonding step of semiconductor chips in the IC lead frame shown in Fig. 1;

Fig. 3 is a top view showing the main part of a remodeled version of the IC lead frame shown in Fig. 1;

Fig. 4 is a diagonal view of the main part of an IC lead frame according to the second embodiment of the present invention;

Fig. 5 is a top view of the broader part of the IC lead frame shown in Fig. 1, designed to aid in understanding the structure of the present invention;

Fig. 6 is a top view of an IC lead frame according to the third embodiment of the invention;

Fig. 7 is a top view of a jig for the IC lead frame shown in Fig. 6, used for bonding semiconductor chips to the frame;

Fig. 8 is a top view showing the main part of the first remodeled version of the IC lead frame shown in Fig. 6;

Fig. 9 is a top view showing the main part of the second remodeled version of the IC lead frame shown in Fig. 6; and

Fig. 10 is a top view showing the main part of the third remodeled version of the IC lead frame shown in Fig. 6.

The embodiments of the present invention will now be explained with reference to the drawings.

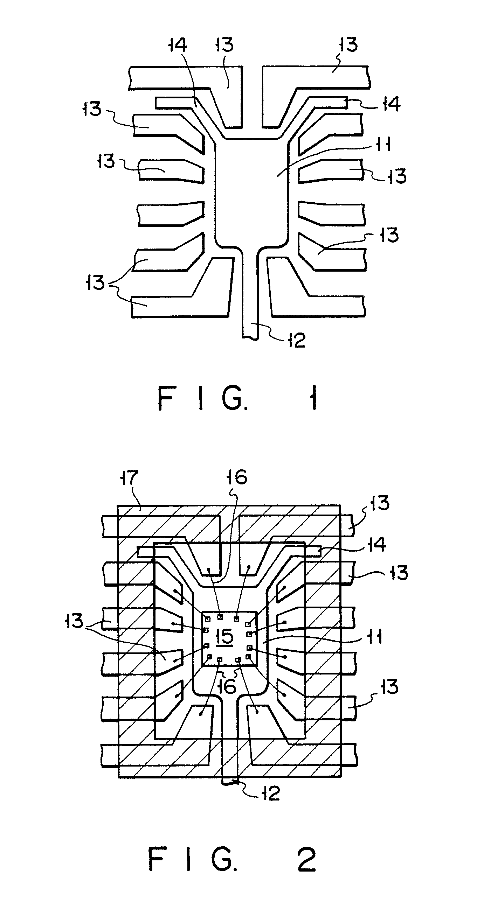

Fig. 1 is a top view showing the characteristics of the main part of an IC lead frame according to the first embodiment of the present invention. For example, it shows a bed of a lead frame of an MCP (multi-chip package) type, and leads located at the periphery of the bed. In fact, there are more than one bed of the lead frame, so as to mount a plurality of bare chips on the same plane. To reduce the size of the lead frame to a minimum, and to avoid complexity, there is only one bed-supporting tie bar.

The bed 11 of the lead frame on which bare chips (not shown) are fixed is supported by means of only one tie bar 12. Leads 13 of the lead frame are formed at the periphery of the bed 11. Helper pins 14 are formed so that they extend one from each corner of that end of bed 11 opposite to that from which the tie bar extends.

The helper pin 14 is provided for supporting the bed in balance, and is of a width such that the pin does not come into contact with leads located on either side thereof, and a length such that it is not exposed along with the outer lead when sealed.

In a bonding step using a lead frame having the above-stated structure, a bare chip 15 is die-bonded to the bed 11, and electrode pads provided on the chip 15 are wire-bonded to the leads 13 by bonding wires 16. At the same time, jig 17, which presses the leads 13 as it exposes the bed 11 and the bed-side end portions of the leads 13, also presses the tips of the helper pins 14. In other words, the leads 13, the tie bar 12, and the helper pins 14 are fixed in the structure as they are sandwiched between the jig 17 and the heater plate (not shown) located underneath the lead frame.

As described, although the bed 11 has only one tie bar 12, the bed 11 can be firmly fixed in the bonding step by means of the helper pins 14 which are provided at the corners of that end of the bed opposite to the end from which the tie bar extends. Consequently, the bonding performance between the lead frame and the semiconductor chips is very much enhanced, greatly reducing the bonding error rate.

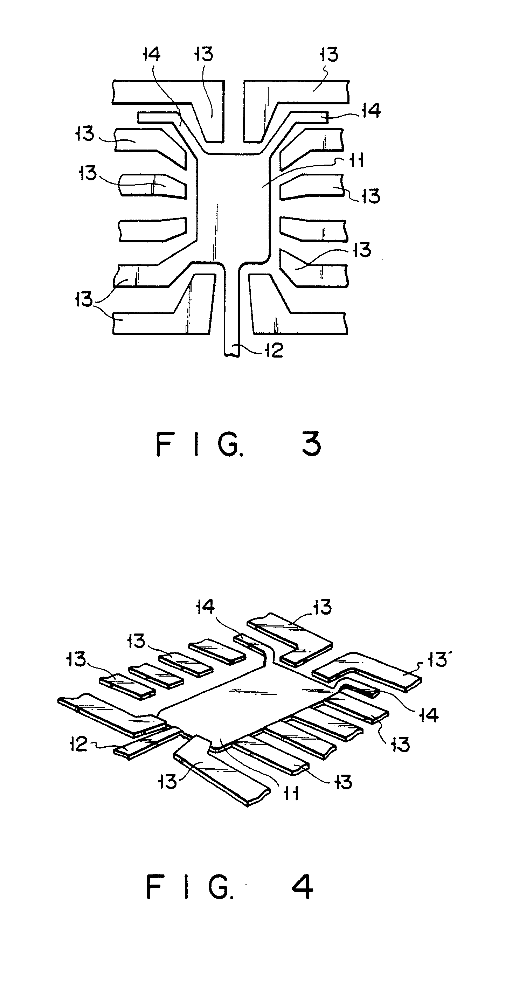

Meanwhile, according to the structure of the lead frame shown in Fig. 3, the bed 11 is connected to one of the leads 13, which also serves as tie bar (in other words, the bed has substantially two tie bars). However, if that one of the leads 13 which is connected to the bed 11 is not located at the position appropriate for firmly fixing the bed as in the case shown in this figure, the helper pins 14 may be provided to support the bed as in the case of Fig. 1.

Fig. 4 is a diagonal view of the main part of the IC lead frame having a structure according to the second embodiment of the invention. This lead frame is of an island-down type in which a bed 11 is located at a position slightly lower than those of surrounding leads 13. With this structure, when a chip is mounted on the bed 11, the top surface of the chip is almost level with the leads 13. Therefore, the loop line of each of the bonding wires connecting the chip and the leads 13 is not elongated, preventing deformation of the bonding wires upon sealing.

Even in a lead frame having the above-stated structure, bed-supporting helper pins 14 may be provided at the corners of that end of the bed opposite to the end from which the tie bar extends, so as to firmly fix the bed 11 during the bonding step.

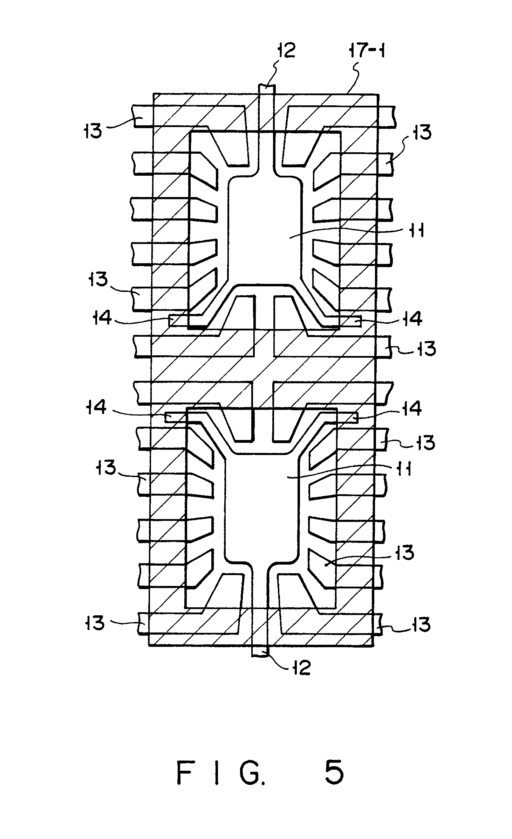

Fig. 5 is a top view showing the broader part of the lead frame shown in Fig. 1, depicting that there are two beds provided, on each of which a bare chip is mounted. As is shown, jig 17-1 has a structure such that the jig pressing the leads 13 as it exposes each of the beds, and the leads 13 surrounding each, also presses helper pins 14 on each side where no tie bar 13 is located. Thus, during the bonding step, the two beds are firmly fixed so that they do not move.

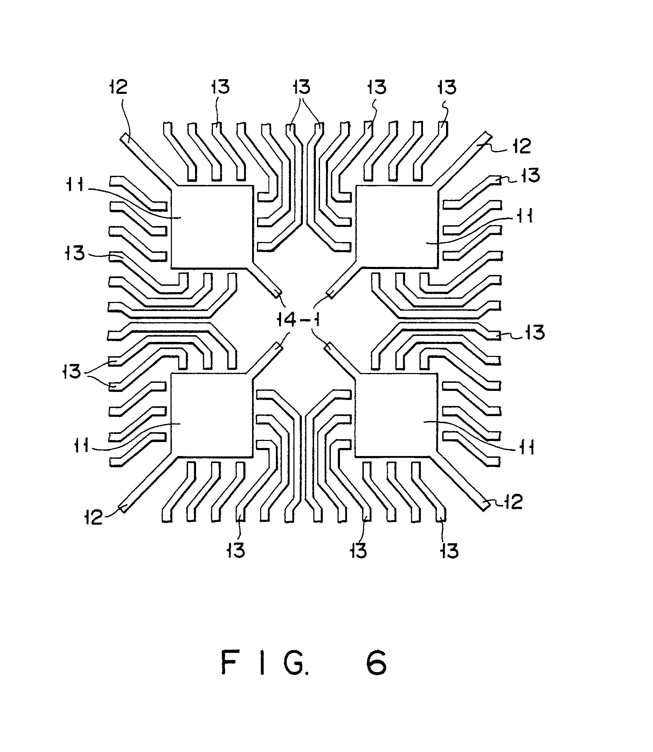

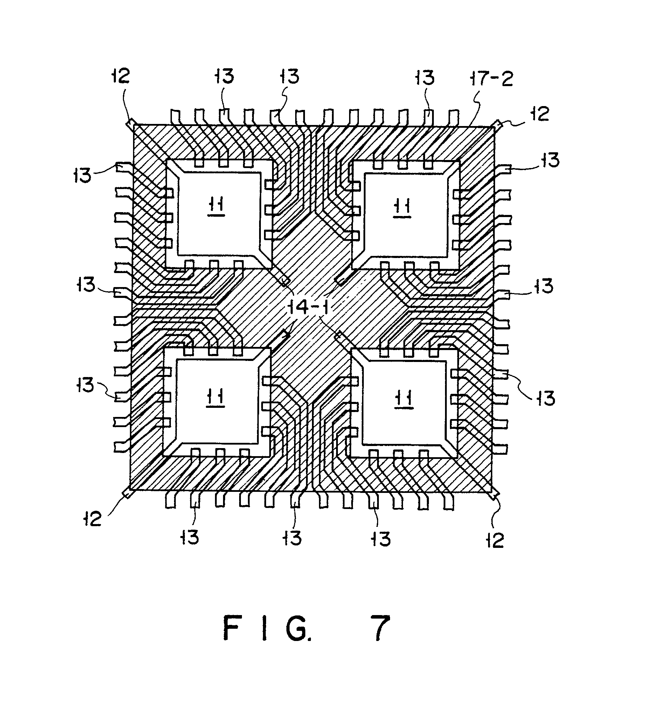

Fig. 6 is a top view of the main part of an IC lead frame according to the third embodiment of the present invention, and illustrates that there are four beds provided, on each of which a bare chip is mounted. A helper pin 14 is provided at that corner of each bed 11 which does not have a tie bar diagonally opposite to that from which tie bar 12 extends. As is shown in Fig. 7, a jig 17-2 has a structure such that the jig pressing the leads 13 as it exposes each of the beds and the leads 13 surrounding each, also presses helper pins 14 on each side where no tie bar 13 is located, in the bonding step. In order to fix a lead frame, the lead frame is sandwiched between the jig 17-2 and a heater plate (not shown) located underneath the lead frame, as in the aforementioned embodiments.

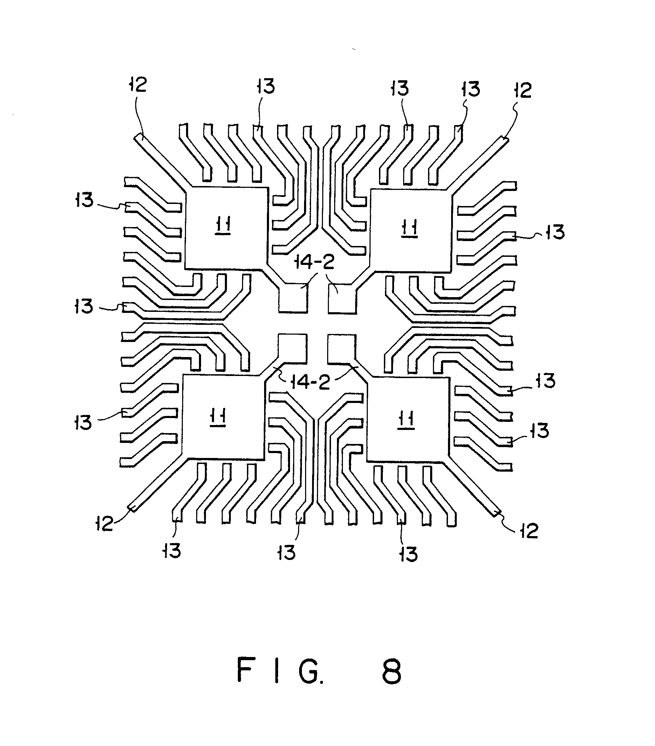

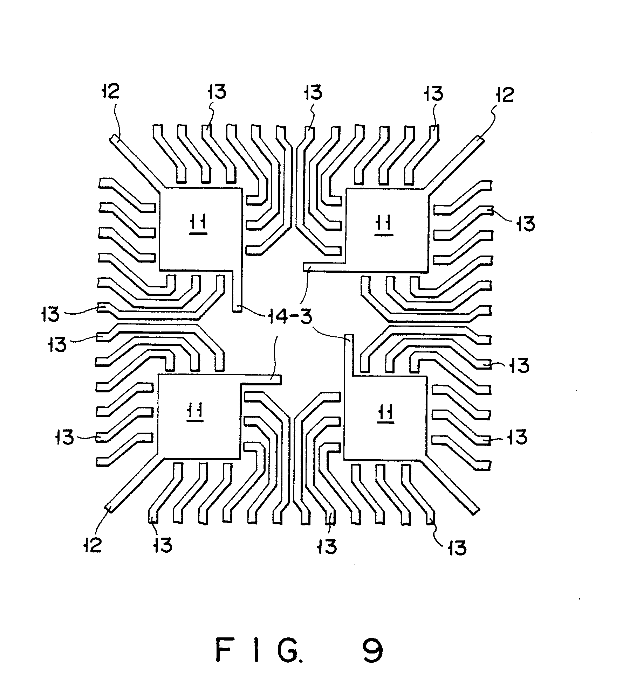

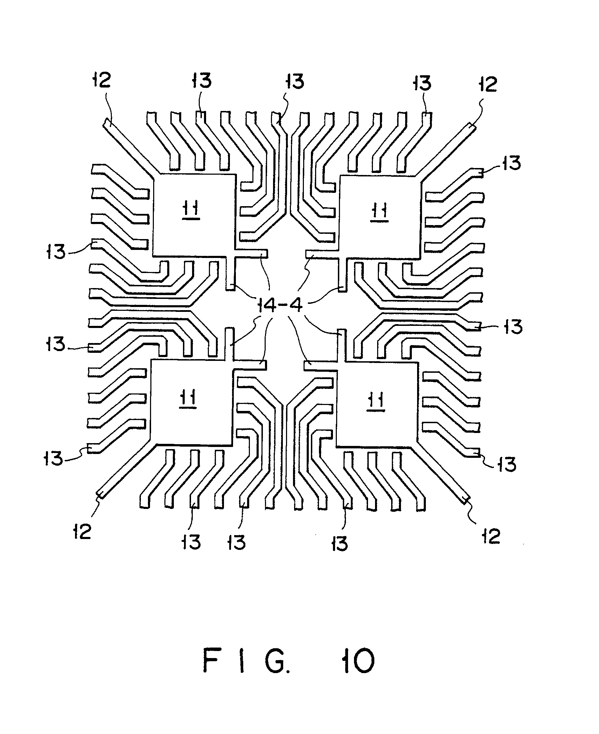

Taking an example of the lead frame shown in Fig. 6, there may be a variety of forms for the helper pin 14-1 as long as the area therefor allows. More specifically, as can be seen in Fig. 8, the section of the helper pin 13-2 which is pressed against the jig is formed larger than the usual case so as to further stabilize the bed. Fig. 9 also illustrates that one side of a bed 11 extends beyond a corner to form a helper pin 14-3, and Fig. 10 depicts that two adjacent sides of a bed 11 extend beyond a corner where the sides intersect, to form two helper pins 14-4.

The island-down type lead frame introduced in Fig. 4, in which the bed 11 is located at a level slightly lower than that of the leads 13, can also be applied in the embodiments shown in Figs. 6, 8, 9 and 10.

As described, according to the present invention, bed-supporting helper pins are provided together with a tie bar which supports the bed of a lead frame; therefore fixing of the bed can be fully assured in a bonding step. Thus, there can be provided an IC lead frame in which bonding is greatly enhanced.

Reference signs in the claims are intended for better understanding and shall not limit the scope.

**Claims**

1. An IC lead frame comprising:

bed (11), on which a semiconductor chip (15) is mounted;

a plurality of leads (13) arranged around said bed (11); and

a bed-supporting helper pin (14) extending inbetween adjacent two of said leads (13) and leaving a distance from an outer lead so as to be held together with said leads by a jig (17) which holds the lead frame during a bonding step of said semiconductor chip (15).

2. An IC lead frame according to claim 1, characterized in that said bed has only one tie bar (12) for supporting said bed.

3. An IC lead frame according to claim 1, characterized in that said bed (11) is located at a position lower than that of said leads, and said helper pin (14) and said tie bar (12) are leveled with each other.

4. An IC lead frame according to claim 1, characterized in that said helper pin (14) extends from that side of said bed opposite from which said tie bar (12) locates.

5. An IC lead frame according to claim 1, characterized in that said helper pin (14) locates between said adjacent two leads (13) at a same distance away from each of the leads.

6. An IC lead frame according to claim 1, characterized in that said helper pin (14) extends in a direction opposite from which said tie bar (12) extends.

7. An IC lead frame according to claim 1, characterized in that said helper pin (14) has a distal portion to be held by said jig (17), having an area larger than a proximal portion thereof.

8. An IC lead frame according to claim 1, characterized in that said helper pin (14) extends beyond a corner of one side of said each bed (11).

9. An IC lead frame comprising:
   a plurality of beds (11), on each of which a semiconductor chip (15) is mounted;
   a plurality of leads (13) arranged around said bed (11); and
   a bed-supporting helper pin (14) extending from a corner of a side of each bed (11), other than that from which a tie bar (12) extends, inbetween adjacent two of said leads (13) so as to be held together with said leads by a jig (17) which holds the lead frame during a bonding step of said semiconductor chip.

10. An IC lead frame according to claim 9, characterized in that said beds (11) are located at a position lower than that of the leads, and said tie bar (12) and the helper pin (14) are leveled with each other.

11. An IC lead frame according to claim 9, characterized in that said helper pin (14) extends in a direction different from that of said tie bar (12) without touching said leads (13), and has a length such that it is not exposed together with an outer lead when sealing the semiconductor chips (15).

12. An IC lead frame according to claim 11, characterized in that said helper pin (14) extends in a direction opposite to that from which said tie bar (12) extends.

13. An IC lead frame according to claim 10, characterized in that said helper pin (14) extends without touching said leads (13) and has a distal portion to be held by said jig (17), having an area larger than a proximal portion thereof.

14. An IC lead frame according to claim 10, characterized in that said helper pin (14) extends beyond a corner of one side of said each bed (11) without touching said leads (13).

F I G. 1

F I G. 2

F I G. 3

F I G. 4

F I G. 5

F I G. 6

F I G. 7

F I G. 8

F I G. 9

FIG. 10